# EUROPEAN PATENT APPLICATION

(11) **EP 4 604 401 A1**
(43) Date of publication of application: **20.08.2025**
(21) Application number: 25156864.8
(22) Date of filing: 10.02.2025
(51) Int. Cl.: H04B 1/38, H04B 1/40, H04B 1/59

(54) **APPARATUS, METHOD, AND COMPUTER PROGRAM**

(30) Priority: 16.02.2024 GB 202402165
(71) Applicant: Nokia Technologies Oy, 02610 Espoo (FI)
(72) Inventor: KIMIONIS, Ioannis, Murray Hill (US); HARREBEK, Johannes, Aalborg (DK); SVENDSEN, Simon, Aalborg (DK); VEJLGAARD, Benny, Gistrup (DK); SÄILY, Mikko, Laukkoski (FI); BARBU, Oana-Elena, Aalborg (DK)
(74) Representative: Nokia EPO representatives

(57) **Abstract**

The disclosure relates to an apparatus comprising: an energy storage; an antenna; a modulator connected to the antenna; an amplifier; means for selectively connecting the amplifier to the energy storage or disconnecting the amplifier from the energy storage; and means for selectively connecting the modulator to the amplifier or disconnecting the modulator from the amplifier.

## Description

### Field of the disclosure

The present disclosure relates to an apparatus, a method, and a computer program for managing a device (e.g., ambient Internet of things device) in a communication system.

### Background

A communication system can be seen as a facility that enables communication sessions between two or more entities such as communication devices, base stations and/or other nodes by providing carriers between the various entities involved in the communications path.

The communication system may be a wireless communication system. Examples of wireless systems comprise public land mobile networks (PLMN) operating based on radio standards such as those provided by 3GPP, satellite based communication systems and different wireless local networks, for example wireless local area networks (WLAN). The wireless systems can typically be divided into cells, and are therefore often referred to as cellular systems.

The communication system and associated devices typically operate in accordance with a given standard or specification which sets out what the various entities associated with the system are permitted to do and how that should be achieved. Communication protocols and/or parameters which shall be used for the connection are also typically defined. Examples of standard are the so-called 5G standards.

### Summary

According to an aspect there is provided a first apparatus comprising: means for transmitting, to a second apparatus, capability information indicating a capability to operate the first apparatus in at least one transmission mode for transmitting a response signal to an activation signal; means for receiving, from the second apparatus, a request to operate the first apparatus in a transmission mode amongst the at least one transmission mode; and means for operating the first apparatus in the first transmission mode amongst the at least one transmission mode.

The first apparatus may comprise: means for receiving, from the second apparatus, a request to transmit the capability information.

The at least one transmission mode may comprise at least one of: a first transmission mode wherein the response signal is transmitted by backscattering the activation signal without amplification; or a second transmission mode wherein the response signal is transmitted by backscattering the activation signal with amplification.

The first apparatus may be an ambient Internet of things device.

The first apparatus may be a ambient Internet of things device type B ambient Internet of things device.

The second apparatus may be a session control unit.

The session control unit may be part of a radio access network or a core network.

The session control unit may be part of a base station or a location management function.

The first apparatus and the second apparatus may communicate directly or indirectly (e.g., via an activator).

The first apparatus may comprise: means for receiving, from the second apparatus, a request to selectively increase a gain of an amplifier or decrease a gain of an amplifier; and means for selectively increasing the gain of the amplifier or decreasing the gain of the amplifier.

According to an aspect there is provided a method comprising: transmitting, to a second apparatus, capability information indicating a capability to operate the first apparatus in at least one transmission mode for transmitting a response signal to an activation signal; receiving, from the second apparatus, a request to operate the first apparatus in a transmission mode amongst the at least one transmission mode; and operating the first apparatus in the first transmission mode amongst the at least one transmission mode.

The method may be performed by a first apparatus.

The method may comprise: receiving, from the second apparatus, a request to transmit the capability information.

The at least one transmission mode may comprise at least one of: a first transmission mode wherein the response signal is transmitted by backscattering the activation signal without amplification; or a second transmission mode wherein the response signal is transmitted by backscattering the activation signal with amplification.

The first apparatus may be an ambient Internet of things device.

The first apparatus may be a ambient Internet of things device type B ambient Internet of things device.

The second apparatus may be a session control unit.

The session control unit may be part of a radio access network or a core network.

The session control unit may be part of a base station or a location management function.

The first apparatus and the second apparatus may communicate directly or indirectly (e.g., via an activator).

The method may comprise: receiving, from the second apparatus, a request to selectively increase a gain of an amplifier or decrease a gain of an amplifier; and selectively increasing the gain of the amplifier or decreasing the gain of the amplifier.

According to an aspect there is provided a first apparatus comprising at least one processor and at least one memory storing instructions that, when executed by the at least one processor, cause the apparatus at least to perform: transmitting, to a second apparatus, capability information indicating a capability to operate the first apparatus in at least one transmission mode for transmitting a response signal to an activation signal; receiving, from the second apparatus, a request to operate the first apparatus in a transmission mode amongst the at least one transmission mode; and operating the first apparatus in the first transmission mode amongst the at least one transmission mode.

According to an aspect there is provided a first apparatus comprising circuitry configured to perform: transmitting, to a second apparatus, capability information indicating a capability to operate the first apparatus in at least one transmission mode for transmitting a response signal to an activation signal; receiving, from the second apparatus, a request to operate the first apparatus in a transmission mode amongst the at least one transmission mode; and operating the first apparatus in the first transmission mode amongst the at least one transmission mode.

According to an aspect there is provided a computer program comprising computer executable code which when run on at least one processor is configured to perform: transmitting, to a second apparatus, capability information indicating a capability to operate the first apparatus in at least one transmission mode for transmitting a response signal to an activation signal; receiving, from the second apparatus, a request to operate the first apparatus in a transmission mode amongst the at least one transmission mode; and operating the first apparatus in the first transmission mode amongst the at least one transmission mode.

According to an aspect there is provided a second apparatus comprising: means for receiving, from a first apparatus, capability information indicating a capability to operate the first apparatus in at least one transmission mode for transmitting a response signal to an activation signal; means for determining to operate the first apparatus in a transmission mode amongst the at least one transmission mode based on the capability information; and means for transmitting, to the first apparatus, a request to operate the first apparatus in the transmission mode amongst the at least one transmission mode.

The second apparatus may comprise: means for transmitting, to the first apparatus, a request for receiving the capability information.

The at least one transmission mode may comprise at least one of: a first transmission mode wherein the response signal is transmitted by backscattering the activation signal without modulation and without amplification; a second transmission mode wherein the response signal is transmitted by backscattering the activation signal with modulation and without amplification to transmit the response signal; or a second transmission mode wherein the response signal is transmitted by backscattering the activation signal with modulation and with amplification to transmit the response signal.

The second apparatus may comprise: means for determining to operate the first apparatus in the transmission mode amongst the at least one transmission mode based on the capability information and at least one measurement of the response signal.

The second apparatus may comprise: means for receiving, from at least one third apparatus, the at least one measurement of the response signal.

The at least one third apparatus may comprise at least one a reader.

The reader may be a user equipment or a base station.

The capability information may indicate a capability to operate the first apparatus in the second transmission mode; and the means for determining to operate the first apparatus in the transmission mode amongst the at least one transmission mode based on the capability information and at least one measurement of the response signal may comprise: means for determining that at least one measurement of the response signal is lower than a first threshold; and means for determining to operate the first apparatus in the second transmission mode.

The capability information may indicate a capability to operate the first apparatus in the first transmission mode or the second transmission mode; and the means for determining to operate the first apparatus in the transmission mode amongst the at least one transmission mode based on the capability information and at least one measurement of the response signal may comprise: means for determining that at least one measurement of the response signal is lower than a first threshold and at least one other measurement of the response signal is greater than a second threshold; and means for determining to operate the first apparatus in the first transmission mode.

The capability information may indicate a capability to operate the first apparatus in the second transmission mode; and the means for determining to operate the first apparatus in the transmission mode amongst the at least one transmission mode based on the capability information and at least one measurement of the response signal may comprise: means for determining that at least one measurement of the response signal is lower than a first threshold and at least one other measurement of the response signal is greater than a second threshold; and means for determining to operate the first apparatus in the second transmission mode with reduced transmission power.

The capability information may indicate a capability to operate the first apparatus in the second transmission mode; and the means for determining to operate the first apparatus in the transmission mode amongst the at least one transmission mode based on the capability information and at least one measurement of the response signal may comprise: means for determining that at least one measurement of the response signal is lower than a first threshold and at least one other measurement of the response signal is greater than a second threshold; and means for determining to operate the first apparatus in the second transmission mode with an alternative modulation or with an alternative activation signal.

The at least one measurement of the response signal may comprise a signal to noise measurement; and/or the at least one measurement of the response signal may comprise a received signal strength indicator measurement.

According to an aspect there is provided a method comprising: receiving, from a first apparatus, capability information indicating a capability to operate the first apparatus in at least one transmission mode for transmitting a response signal to an activation signal; determining to operate the first apparatus in a transmission mode amongst the at least one transmission mode based on the capability information; and transmitting, to the first apparatus, a request to operate the first apparatus in the transmission mode amongst the at least one transmission mode.

The method may be performed by a second apparatus.

The method may comprise: transmitting, to the first apparatus, a request for receiving the capability information.

The at least one transmission mode may comprise at least one of: a first transmission mode wherein the response signal is transmitted by backscattering the activation signal without modulation and without amplification; a second transmission mode wherein the response signal is transmitted by backscattering the activation signal with modulation and without amplification to transmit the response signal; or a second transmission mode wherein the response signal is transmitted by backscattering the activation signal with modulation and with amplification to transmit the response signal.

The method may comprise: determining to operate the first apparatus in the transmission mode amongst the at least one transmission mode based on the capability information and at least one measurement of the response signal.

The method may comprise: receiving, from at least one third apparatus, the at least one measurement of the response signal.

The at least one third apparatus may comprise at least one a reader.

The reader may be a user equipment or a base station.

The capability information may indicate a capability to operate the first apparatus in the second transmission mode; and determining to operate the first apparatus in the transmission mode amongst the at least one transmission mode based on the capability information and at least one measurement of the response signal may comprise: determining that at least one measurement of the response signal is lower than a first threshold; and determining to operate the first apparatus in the second transmission mode.

The capability information may indicate a capability to operate the first apparatus in the first transmission mode or the second transmission mode; and determining to operate the first apparatus in the transmission mode amongst the at least one transmission mode based on the capability information and at least one measurement of the response signal may comprise: determining that at least one measurement of the response signal is lower than a first threshold and at least one other measurement of the response signal is greater than a second threshold; and determining to operate the first apparatus in the first transmission mode.

The capability information may indicate a capability to operate the first apparatus in the second transmission mode; and determining to operate the first apparatus in the transmission mode amongst the at least one transmission mode based on the capability information and at least one measurement of the response signal may comprise: determining that at least one measurement of the response signal is lower than a first threshold and at least one other measurement of the response signal is greater than a second threshold; and determining to operate the first apparatus in the second transmission mode with reduced transmission power.

The capability information may indicate a capability to operate the first apparatus in the second transmission mode; and determining to operate the first apparatus in the transmission mode amongst the at least one transmission mode based on the capability information and at least one measurement of the response signal may comprise: determining that at least one measurement of the response signal is lower than a first threshold and at least one other measurement of the response signal is greater than a second threshold; and determining to operate the first apparatus in the second transmission mode with an alternative modulation or with an alternative activation signal.

The at least one measurement of the response signal may comprise a signal to noise measurement; and/or the at least one measurement of the response signal may comprise a received signal strength indicator measurement.

According to an aspect there is provided a second apparatus comprising at least one processor and at least one memory storing instructions that, when executed by the at least one processor, cause the apparatus at least to perform: receiving, from a first apparatus, capability information indicating a capability to operate the first apparatus in at least one transmission mode for transmitting a response signal to an activation signal; determining to operate the first apparatus in a transmission mode amongst the at least one transmission mode based on the capability information; and transmitting, to the first apparatus, a request to operate the first apparatus in the transmission mode amongst the at least one transmission mode.

According to an aspect there is provided a second apparatus comprising circuitry configured to perform: receiving, from a first apparatus, capability information indicating a capability to operate the first apparatus in at least one transmission mode for transmitting a response signal to an activation signal; determining to operate the first apparatus in a transmission mode amongst the at least one transmission mode based on the capability information; and transmitting, to the first apparatus, a request to operate the first apparatus in the transmission mode amongst the at least one transmission mode.

According to an aspect there is provided a computer program comprising computer executable code which when run on at least one processor is configured to perform: receiving, from a first apparatus, capability information indicating a capability to operate the first apparatus in at least one transmission mode for transmitting a response signal to an activation signal; determining to operate the first apparatus in a transmission mode amongst the at least one transmission mode based on the capability information; and transmitting, to the first apparatus, a request to operate the first apparatus in the transmission mode amongst the at least one transmission mode.

According to an aspect there is provided a first apparatus comprising: means for receiving, from a second apparatus, a request to operate the first apparatus in a first transmission mode wherein a response signal is transmitted by backscattering an activation signal without amplification; means for operating the first apparatus in the first transmission mode; means for receiving, from the second apparatus, a request to operate the first apparatus in a second transmission mode wherein a response signal is transmitted by backscattering an activation signal with amplification; and means for operating the first apparatus in the second transmission mode.

In the first transmission mode the response signal may be transmitted by backscattering the activation signal with modulation and without amplification; or in the first transmission mode the response signal may be transmitted by backscattering the activation signal without modulation and without amplification.

In the second transmission mode the response signal may be transmitted by backscattering the activation signal with modulation and with amplification to transmit the response signal; or in the second transmission mode the response signal may be transmitted by backscattering the activation signal without modulation and with amplification to transmit the response signal.

The first apparatus may be an ambient Internet of things device.

The first apparatus may be an ambient Internet of things device type B ambient Internet of things device.

The second apparatus may be a session control unit.

The session control unit may be part of a radio access network or a core network

The session control unit may be part of a base station or a location management function.

The first apparatus and the second apparatus may communicate directly or indirectly (e.g., via an activator).

The first apparatus may comprise: means for receiving, from the second apparatus, a request to selectively increase a gain of an amplifier or decrease a gain of an amplifier; and means for selectively increasing the gain of the amplifier or decreasing the gain of the amplifier.

According to an aspect there is provided a method comprising: receiving, from a second apparatus, a request to operate the first apparatus in a first transmission mode wherein a response signal is transmitted by backscattering an activation signal without amplification; operating the first apparatus in the first transmission mode; receiving, from the second apparatus, a request to operate the first apparatus in a second transmission mode wherein a response signal is transmitted by backscattering an activation signal with amplification; and operating the first apparatus in the second transmission mode.

The method may be performed by a first apparatus.

In the first transmission mode the response signal may be transmitted by backscattering the activation signal with modulation and without amplification; or in the first transmission mode the response signal may be transmitted by backscattering the activation signal without modulation and without amplification.

In the second transmission mode the response signal may be transmitted by backscattering the activation signal with modulation and with amplification to transmit the response signal; or in the second transmission mode the response signal may be transmitted by backscattering the activation signal without modulation and with amplification to transmit the response signal.

The first apparatus may be an ambient Internet of things device.

The first apparatus may be an ambient Internet of things device type B ambient Internet of things device.

The second apparatus may be a session control unit.

The session control unit may be part of a radio access network or a core network

The session control unit may be part of a base station or a location management function.

The first apparatus and the second apparatus may communicate directly or indirectly (e.g., via an activator).

The method may comprise: receiving, from the second apparatus, a request to selectively increase a gain of an amplifier or decrease a gain of an amplifier; and selectively increasing the gain of the amplifier or decreasing the gain of the amplifier.

According to an aspect there is provided a first apparatus comprising at least one processor and at least one memory storing instructions that, when executed by the at least one processor, cause the apparatus at least to perform: receiving, from a second apparatus, a request to operate the first apparatus in a first transmission mode wherein a response signal is transmitted by backscattering an activation signal without amplification; operating the first apparatus in the first transmission mode; receiving, from the second apparatus, a request to operate the first apparatus in a second transmission mode wherein a response signal is transmitted by backscattering an activation signal with amplification; and operating the first apparatus in the second transmission mode.

According to an aspect there is provided a first apparatus comprising circuitry configured to perform: receiving, from a second apparatus, a request to operate the first apparatus in a first transmission mode wherein a response signal is transmitted by backscattering an activation signal without amplification; operating the first apparatus in the first transmission mode; receiving, from the second apparatus, a request to operate the first apparatus in a second transmission mode wherein a response signal is transmitted by backscattering an activation signal with amplification; and operating the first apparatus in the second transmission mode.

According to an aspect there is provided a computer program comprising computer executable code which when run on at least one processor is configured to perform: receiving, from a second apparatus, a request to operate the first apparatus in a first transmission mode wherein a response signal is transmitted by backscattering an activation signal without amplification; operating the first apparatus in the first transmission mode; receiving, from the second apparatus, a request to operate the first apparatus in a second transmission mode wherein a response signal is transmitted by backscattering an activation signal with amplification; and operating the first apparatus in the second transmission mode.

According to an aspect there is provided a second apparatus comprising: means for determining to operate a first apparatus in a first transmission mode wherein a response signal is transmitted by backscattering an activation signal without amplification; means for transmitting, to the first apparatus, a request to operate the first apparatus in the first transmission mode; means for determining to operate the first apparatus in a second transmission mode wherein a response signal is transmitted by backscattering an activation signal with amplification; and means for transmitting, to the first apparatus, a request to operate the first apparatus in the second transmission mode.

In the first transmission mode the response signal may be transmitted by backscattering the activation signal with modulation and without amplification; or in the first transmission mode the response signal may be transmitted by backscattering the activation signal without modulation and without amplification.

In the second transmission mode the response signal may be transmitted by backscattering the activation signal with modulation and with amplification to transmit the response signal; or in the second transmission mode the response signal may be transmitted by backscattering the activation signal without modulation and with amplification to transmit the response signal.

The second apparatus may comprise: means for receiving, from at least one third apparatus, at least one measurement of the response signal.

The at least one third apparatus may comprise at least one reader.

The reader may be a user equipment or a base station.

The second apparatus may comprise: means for determining that at least one measurement of the response signal is lower than a first threshold; and means for determining to operate the first apparatus in the second transmission mode is based on the at least one measurement of the response signal being lower than a first threshold.

The second apparatus may comprise: means for determining that at least one measurement of the response signal is lower than a first threshold and at least one other measurement of the response signal is greater than a second threshold; means for determining to operate the first apparatus in the first transmission mode based on the at least one measurement of the response signal being lower than the first threshold and the at least one other measurement of the response signal being greater than a second threshold; and means for transmitting, to the first apparatus, a request to operate the first apparatus in the first transmission mode.

The second apparatus may comprise: means for determining that at least one measurement of the response signal is lower than a first threshold and at least one other measurement of the response signal is greater than a second threshold; means for determining to operate the first apparatus in the second transmission mode with reduced transmission power based on the at least one measurement of the response signal being lower than the first threshold and the at least one other measurement of the response signal being greater than a second threshold; and means for transmitting, to the first apparatus, a request to operate the first apparatus in the second transmission mode with reduced transmission power.

The second apparatus may comprise: means for determining that at least one measurement of the response signal is lower than a first threshold and at least one other measurement of the response signal is greater than a second threshold; and means for determining to operate the first apparatus in the second transmission mode with an alternative modulation or with an alternative activation signal based on the at least one measurement of the response signal being lower than the first threshold and the at least one other measurement of the response signal being greater than a second threshold; and means for transmitting, to the first apparatus, a request to operate the first apparatus in the second transmission mode with an alternative modulation or with an alternative activation signal.

The at least one measurement of the response signal may comprise a signal to noise measurement; and/or the at least one other measurement of the response signal comprises a received signal strength indicator measurement.

According to an aspect there is provided a method comprising: determining to operate a first apparatus in a first transmission mode wherein a response signal is transmitted by backscattering an activation signal without amplification; transmitting, to the first apparatus, a request to operate the first apparatus in the first transmission mode; determining to operate the first apparatus in a second transmission mode wherein a response signal is transmitted by backscattering an activation signal with amplification; and transmitting, to the first apparatus, a request to operate the first apparatus in the second transmission mode.

The method may be performed by a second apparatus.

In the first transmission mode the response signal may be transmitted by backscattering the activation signal with modulation and without amplification; or in the first transmission mode the response signal may be transmitted by backscattering the activation signal without modulation and without amplification.

In the second transmission mode the response signal may be transmitted by backscattering the activation signal with modulation and with amplification to transmit the response signal; or in the second transmission mode the response signal may be transmitted by backscattering the activation signal without modulation and with amplification to transmit the response signal.

The method may comprise: receiving, from at least one third apparatus, at least one measurement of the response signal.

The at least one third apparatus may comprise at least one reader.

The reader may be a user equipment or a base station.

The method may comprise: determining that at least one measurement of the response signal is lower than a first threshold; and means for determining to operate the first apparatus in the second transmission mode is based on the at least one measurement of the response signal being lower than a first threshold.

The method may comprise: determining that at least one measurement of the response signal is lower than a first threshold and at least one other measurement of the response signal is greater than a second threshold; determining to operate the first apparatus in the first transmission mode based on the at least one measurement of the response signal being lower than the first threshold and the at least one other measurement of the response signal being greater than a second threshold; and transmitting, to the first apparatus, a request to operate the first apparatus in the first transmission mode.

The method may comprise: determining that at least one measurement of the response signal is lower than a first threshold and at least one other measurement of the response signal is greater than a second threshold; determining to operate the first apparatus in the second transmission mode with reduced transmission power based on the at least one measurement of the response signal being lower than the first threshold and the at least one other measurement of the response signal being greater than a second threshold; and transmitting, to the first apparatus, a request to operate the first apparatus in the second transmission mode with reduced transmission power.

The method may comprise: determining that at least one measurement of the response signal is lower than a first threshold and at least one other measurement of the response signal is greater than a second threshold; and determining to operate the first apparatus in the second transmission mode with an alternative modulation or with an alternative activation signal based on the at least one measurement of the response signal being lower than the first threshold and the at least one other measurement of the response signal being greater than a second threshold; and transmitting, to the first apparatus, a request to operate the first apparatus in the second transmission mode with an alternative modulation or with an alternative activation signal.

The at least one measurement of the response signal may comprise a signal to noise measurement; and/or the at least one other measurement of the response signal comprises a received signal strength indicator measurement.

According to an aspect there is provided a second apparatus comprising at least one processor and at least one memory storing instructions that, when executed by the at least one processor, cause the apparatus at least to perform: determining to operate a first apparatus in a first transmission mode wherein a response signal is transmitted by backscattering an activation signal without amplification; transmitting, to the first apparatus, a request to operate the first apparatus in the first transmission mode; determining to operate the first apparatus in a second transmission mode wherein a response signal is transmitted by backscattering an activation signal with amplification; and transmitting, to the first apparatus, a request to operate the first apparatus in the second transmission mode.

According to an aspect there is provided a second apparatus comprising circuitry configured to perform: determining to operate a first apparatus in a first transmission mode wherein a response signal is transmitted by backscattering an activation signal without amplification; transmitting, to the first apparatus, a request to operate the first apparatus in the first transmission mode; determining to operate the first apparatus in a second transmission mode wherein a response signal is transmitted by backscattering an activation signal with amplification; and transmitting, to the first apparatus, a request to operate the first apparatus in the second transmission mode.

According to an aspect there is provided a computer program comprising computer executable code which when run on at least one processor is configured to perform: determining to operate a first apparatus in a first transmission mode wherein a response signal is transmitted by backscattering an activation signal without amplification; transmitting, to the first apparatus, a request to operate the first apparatus in the first transmission mode; determining to operate the first apparatus in a second transmission mode wherein a response signal is transmitted by backscattering an activation signal with amplification; and transmitting, to the first apparatus, a request to operate the first apparatus in the second transmission mode.

According to an aspect there is provided an apparatus comprising: an energy storage;
an antenna; a modulator connected to the antenna; an amplifier; means for selectively connecting the amplifier to the energy storage or disconnecting the amplifier from the energy storage; and means for selectively connecting the modulator to the amplifier or disconnecting the modulator from the amplifier.

The means for selectively connecting the amplifier to the energy storage or disconnecting the amplifier from the energy storage may comprise means for selectively connecting a bias of the amplifier to the energy storage or disconnecting a bias of the amplifier from the energy storage.

The means for selectively connecting the amplifier to the energy storage or disconnecting the amplifier from the energy storage may comprise a first switch.

The means for selectively connecting the modulator to the amplifier or disconnected the modulator from the amplifier may comprise a second switch.

The amplifier may be a reflection amplifier.

The modulator may be a binary phase shift keying modulator.

The modulator may be an on off keying modulator.

The apparatus may comprise: means for receiving, from a second apparatus, a request to operate the apparatus in a first transmission mode wherein a response signal is transmitted by backscattering an activation signal without amplification; means for transmitting a control signal to the means for selectively connecting the amplifier to the energy storage or disconnecting the amplifier from the energy storage so that the amplifier is disconnected from the energy storage; and means for transmitting a control signal to the means for connecting the modulator to the amplifier or disconnected from the amplifier so that the modulator is disconnected from the amplifier.

The apparatus may comprise: means for receiving, from a second apparatus, a request to operate the apparatus in a second transmission mode wherein a response signal is transmitted by backscattering an activation signal with amplification; means for transmitting a control signal to the means for selectively connecting the amplifier to the energy storage or disconnecting the amplifier from the energy storage so that the amplifier is connected to the energy storage; and means for transmitting a control signal to the means for connecting the modulator to the amplifier or disconnected from the amplifier so that the modulator is connected to the amplifier.

The apparatus may comprise: means for selectively increasing a gain of the amplifier or decreasing a gain of the amplifier.

The apparatus may be an ambient Internet of things device.

The apparatus may be an ambient Internet of things device type B ambient Internet of things device.

The second apparatus may be a session control unit.

The session control unit may be part of a radio access network or a core network

The session control unit may be part of a base station or a location management function.

The apparatus and the second apparatus may communicate directly or indirectly (e.g., via an activator).

According to an aspect there is provided a method performed by an apparatus comprising an energy storage, an antenna, a modulator connected to the antenna and an amplifier, comprising: selectively connecting the amplifier to the energy storage or disconnecting the amplifier from the energy storage; and selectively connecting the modulator to the amplifier or disconnecting the modulator from the amplifier.

According to an aspect there is provided an apparatus comprising an energy storage;
an antenna; a modulator connected to the antenna; an amplifier; at least one processor and at least one memory storing instructions that, when executed by the at least one processor, cause the apparatus at least to: selectively connect the amplifier to the energy storage or disconnect the amplifier from the energy storage; and
selectively connect the modulator to the amplifier or disconnect the modulator from the amplifier.

According to an aspect there is provided an apparatus comprising an energy storage;
an antenna; a modulator connected to the antenna; an amplifier; and circuitry configured to: selectively connect the amplifier to the energy storage or disconnect the amplifier from the energy storage; and selectively connect the modulator to the amplifier or disconnect the modulator from the amplifier.

According to an aspect there is provided a computer program comprising computer executable code which when run on at least one processor is configured to: selectively connect an amplifier to energy storage or disconnect an amplifier from an energy storage; and selectively connect a modulator to an amplifier or disconnect a modulator from an amplifier.

According to an aspect, there is provided a computer readable medium comprising program instructions stored thereon for performing at least one of the above methods.

According to an aspect, there is provided a non-transitory computer readable medium comprising program instructions stored thereon for performing at least one of the above methods.

According to an aspect, there is provided a non-volatile tangible memory medium comprising program instructions stored thereon for performing at least one of the above methods.

**In** the above, many different aspects have been described. **It** should be appreciated that further aspects may be provided by the combination of any two or more of the aspects described above.

Various other aspects are also described in the following detailed description and in the attached claims.

### List of abbreviations

- AF:: Application Function
- AIoT/ AloT:: Ambient Internet of Things
- AMF:: Access and Mobility Management Function
- BPSK:: Binary Phase Shift Keying
- BS:: Base Station
- CU:: Centralized Unit
- DL:: Downlink
- DU:: Distributed Unit
- gNB:: gNodeB
- HSS:: Home Subscriber Server
- IoT:: Internet of Things
- LTE:: Long Term Evolution
- MAC:: Medium Access Control
- MS:: Mobile Station
- MTC:: Machine Type Communication
- NEF:: Network Exposure Function
- NF:: Network Function
- NR:: New radio
- NRF:: Network Repository Function
- RAM:: Random Access Memory
- (R)AN:: (Radio) Access Network
- ROM:: Read Only Memory
- RSSI:: Received Signal Strength Indicator
- SCU:: Session Control Unit
- SMF:: Session Management Function
- SNR:: Signal to Noise Ration
- UE:: User Equipment
- 5G:: 5^{th} Generation
- 5GC:: 5G Core network
- 5GS:: 5G System

### Brief Description of the Figures

Embodiments will now be described, by way of example only, with reference to the accompanying Figures in which:
Fig. 1 shows a schematic representation of an example 5G system;
Fig. 2 shows a schematic representation of an example control apparatus;
Fig. 3 shows a schematic representation of an example user equipment;
Fig. 4 shows a schematic representation of an example activator user equipment, an ambient Internet of things device and a reader user equipment;
Fig.5 shows a schematic representation of an example ambient Internet of things device comprising a reflection amplifier, a binary phase shift keying modulator and an antenna;
Fig. 6 shows an example signaling diagram of a process for managing an ambient Internet of things device;
Fig. 7 shows a schematic representation of an example ambient Internet of things device;
Fig. 8 shows a block diagram of a process for managing an ambient Internet of things device;
Fig. 9 shows a block diagram of a process for managing an ambient Internet of things device;
Fig. 10 shows a block diagram of a process for managing an ambient Internet of things device;
Fig. 11 shows a block diagram of a process for managing an ambient Internet of things device;
Fig. 12 shows a block diagram of a process for managing an ambient Internet of things device; and
Fig. 13 shows a schematic representation of a non-volatile memory medium storing instructions which when executed by a processor allow a processor to perform one or more of the steps of the methods of Fig. 8 to Fig. 12.

### Detailed Description of the Figures

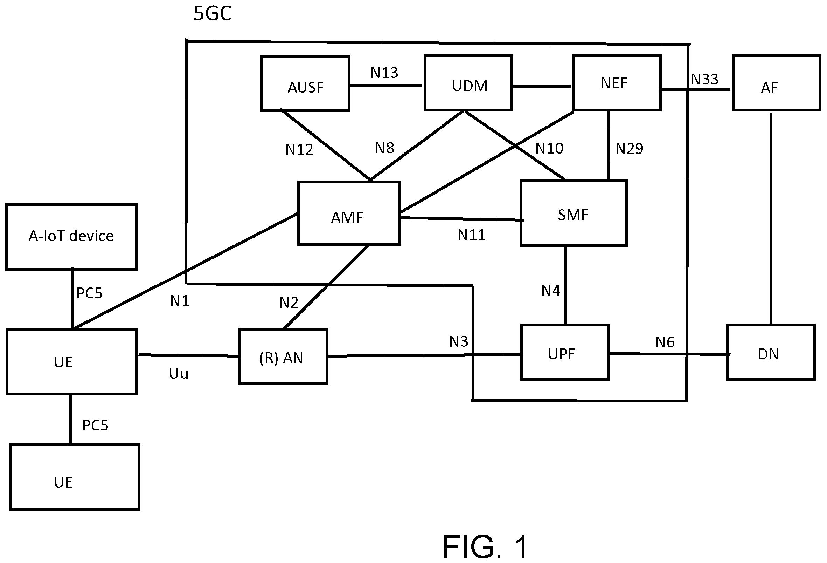

In the following certain embodiments are explained with reference to mobile communication devices capable of communication via a wireless cellular system and mobile communication systems serving such mobile communication devices. Before explaining in detail the exemplifying embodiments, certain general principles of a wireless communication system, access systems thereof, and mobile communication devices are briefly explained with reference to Fig. 1, Fig.2 and Fig.3 to assist in understanding the technology underlying the described examples.

FIG. 1 shows a schematic representation of an example 5G system (5GS). The 5GS may comprises Internet of things (IoT) devices, user equipment (UEs), a (radio) access network ((R)AN), a 5G core network (5GC), one or more application functions (AF) and one or more data networks (DN).

The IoT devices may comprise ambient IoT (AIoT) devices. An AIoT device may be configured to measure ambient conditions, such as location, temperature, pressure, noise, light or other ambient conditions. An AIoT device may comprise a sensor.

The UEs may comprise activator UEs, reader UEs or activator and reader UEs. An activator UE may be configured to transmit an activation signal to an AIoT device to trigger the AIoT device to transmit a response signal to a reader UE. A reader UE may be configured to receive a response signal from an AIoT device and to transmit a report signal to the 5G(R)AN.

The AIoT device may be of different types.

An AIoT device type A may refer to an AIoT device that does not have energy storage and that is not capable of transmitting a response signal to a reader UE independent from an activation signal received from an activator UE. The AIoT may comprise a passive radio frequency transmission component. The AIoT device may be capable of transmitting a response signal dependent from an activation signal received from an activator UE. The response signal may be a backscattered (i.e. reflected) modulation of the activation signal received from an activator UE. The modulation may be used to convey content, such as an identifier of the AIoT device or a measurement performed by the AIoT device. The power of the activation signal received from the activator UE may be controlled by the activator UE.

An AIoT device type B may refer to an AIoT device that has energy storage and that is not capable of transmitting a response signal to a reader UE independent from an activation signal received from an activator UE. The AIoT may comprise a passive radio frequency transmission component. The AIoT device may be capable of transmitting a response signal dependent from an activation signal received from an activator UE. The response signal may be a backscattered (i.e. reflected) modulation of the activation signal received from an activator UE, such as an identifier of the AIoT device or a measurement performed by the AIoT device. The power of the activation signal received from the activator UE may be controlled by the activator UE. The power of the response signal transmitted by the AIoT device may be controlled by the AIoT device.

An AIoT device type C may refer to an AIoT device that has energy storage and that is capable of transmitting a response signal independent from an activation signal received from an activator UE. The AIoT may comprise an active radio frequency transmission component. The power of the activation signal received from the activator UE may be controlled by the activator UE. The power of the response signal transmitted by the AIoT device may be controlled by the AIoT device.

In this disclosure, for the case of AIoT device type A, AIoT device type B or AIoT device type C, the expressions "activation signal", "illumination signal" and "incident signal" may be used interchangeably.

In this disclosure, for the case of AIoT device type A and AIoT device type B, the expressions "response signal", "backscattered signal" or "reflected signal" may be used interchangeably.

The 5G (R)AN may comprise one or more gNodeBs (gNBs). The gNodeBs may comprise one or more gNB distributed unit functions connected to one or more gNB centralized unit functions.

The gNodeBs may comprise activator gNodeBs, reader gNodeBs or activator and reader gNodeBs.

The 5GC may comprise an access and mobility management function (AMF), a session management function (SMF), an authentication server function (AUSF), a user data management (UDM), a user plane function (UPF), a network exposure function (NEF).

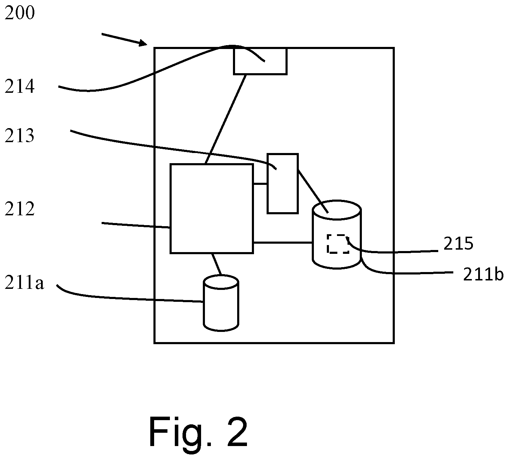

Fig. 2 illustrates an example of a control apparatus 200 for controlling a function of the (R)AN or the 5GC as illustrated on Fig. 1. The control apparatus may comprise at least one random access memory (RAM) 211a, at least on read only memory (ROM) 211b, at least one processor 212, 213 and an input/output interface 214. The at least one processor 212, 213 may be coupled to the RAM 211a and the ROM 211b. The at least one processor 212, 213 may be configured to execute an appropriate software code 215. The software code 215 may for example allow to perform one or more steps to perform one or more of the present aspects. The software code 215 may be stored in the ROM 211b. The control apparatus 200 may be interconnected with another control apparatus 200 controlling another function of the 5G (R)AN or the 5GC. In some embodiments, each function of the (R)AN or the 5GC comprises a control apparatus 200. In alternative embodiments, two or more functions of the (R)AN or the 5GC may share a control apparatus.

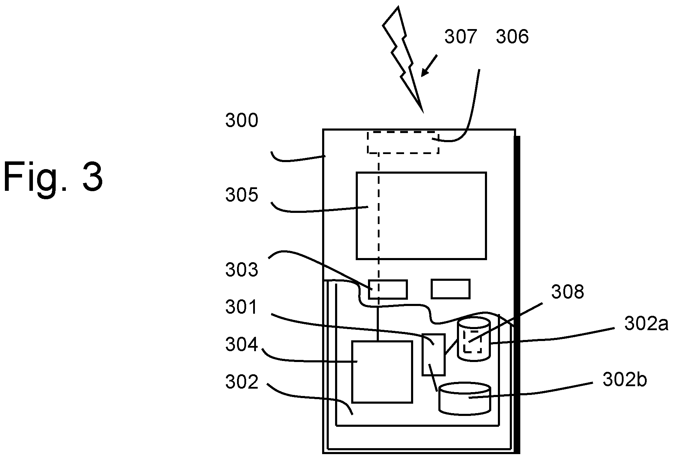

Fig. 3 illustrates an example of a user equipment 300, such as the terminal illustrated on Fig. 1. The UE 300 may be provided by any device capable of sending and receiving radio signals. Non-limiting examples comprise a user equipment, a mobile station (MS) or mobile device such as a mobile phone or what is known as a 'smart phone', a computer provided with a wireless interface card or other wireless interface facility (e.g., USB dongle), a personal data assistant (PDA) or a tablet provided with wireless communication capabilities, a machine-type communications (MTC) device, a Cellular Internet of things (CIoT) device or any combinations of these or the like. The UE 300 may provide, for example, communication of data for carrying communications. The communications may be one or more of voice, electronic mail (email), text message, multimedia, data, machine data and so on.

The UE 300 may receive signals over an air or radio interface 307 via appropriate apparatus for receiving and may transmit signals via appropriate apparatus for transmitting radio signals. In Fig. 3 transceiver apparatus is designated schematically by block 306. The transceiver apparatus 306 may be provided for example by means of a radio part and associated antenna arrangement. The antenna arrangement may be arranged internally or externally to the mobile device.

The UE 300 may be provided with at least one processor 301, at least one memory ROM 302a, at least one RAM 302b and other possible components 303 for use in software and hardware aided execution of tasks it is designed to perform, including control of access to and communications with access systems and other communication devices. The at least one processor 301 is coupled to the RAM 302b and the ROM 302a. The at least one processor 301 may be configured to execute an appropriate software code 308. The software code 308 may for example allow to perform one or more of the present aspects. The software code 308 may be stored in the ROM 302a.

The processor, storage and other relevant control apparatus can be provided on an appropriate circuit board and/or in chipsets. This feature is denoted by reference 304. The device may optionally have a user interface such as keypad 305, touch sensitive screen or pad, combinations thereof or the like. Optionally one or more of a display, a speaker and a microphone may be provided depending on the type of the device.

One or more aspect of this disclosure provides a mechanism for managing an AIoT device, in particular an AIoT device type B AIoT device.

As explained above, for the case of AIoT device type B, the AIoT device does not have energy storage and is not capable of transmitting a response signal to a reader UE independent from an activation signal received from an activator UE. The AIoT may comprise a passive radio frequency transmission component. The AIoT device may be capable of transmitting a response signal dependent from an activation signal received from an activator UE. The response signal may be a backscattered (i.e. reflected) modulation of the activation signal received from an activator UE. The modulation may be used to convey content, such as an identifier of the AIoT device or a measurement performed by the AIoT device. The power of the activation signal received from the activator UE may be controlled by the activator UE. The power of the response signal transmitted by the AIoT device may be controlled by the AIoT device.

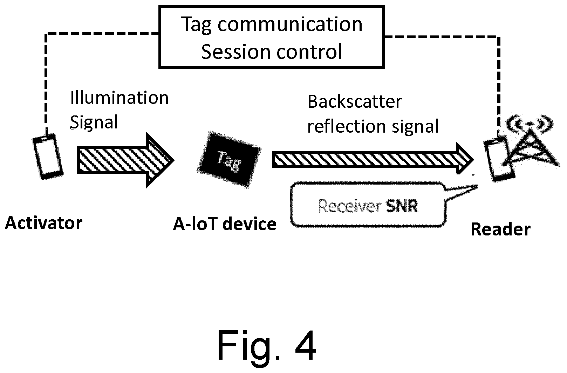

Fig. 4 shows a schematic representation of an activator UE, an AIoT device and a reader UE. The AIoT device may comprise an AIoT device type B AIoT device.

It will be understood that the activator UE may be replaced by an activator gNB and/or the reader UE may be replaced by a reader gNB.

An AIoT device type B AIoT device may implement binary phase shift keying (BPSK) modulation of the activation signal to transmit the response signal. The BPSK modulation may be performed using a BPSK modulator comprising a switch, a first passive load (e.g., phase equal to 0 degree) and a second passive load (e.g., phase equal to 90 degrees). The BPSK modulation may attenuate the activation signal and therefore the signal to noise ratio of the response signal measured by the reader UE may be reduced.

An AIoT device type B AIoT device may implement amplification of the activation signal to transmit the response signal. The amplification may be performed using a reflection amplifier (e.g., a low power reflection amplifier). The reflection amplifier may be a single port reflection amplifier. The reflection amplifier may be a sub-biased oscillator that operates with low current (micro amp to milliamp current consumption). The reflection amplifier may present a negative resistance. The negative resistance may translate into a reflection gain. The reflection gain may be adjusted so that the signal to noise ratio of the response signal measured by the reader UE may be increased.

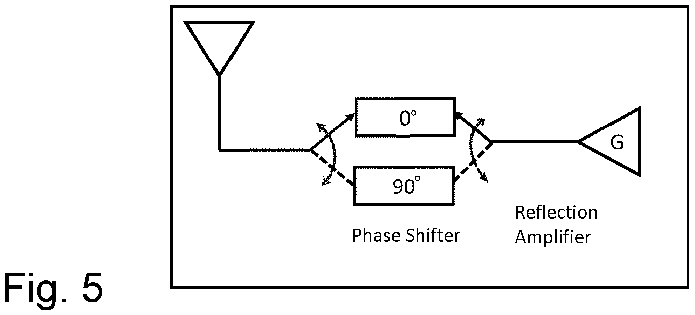

Fig.5 shows a schematic representation of AIoT device type B AIoT device comprising a reflection amplifier, a BPSK modulator and an antenna.

A potential problem with the reflection amplifier may be stability. When a high-power activation signal is received by the reflection amplifier, the reflection amplifier may become unstable and start oscillating. This may result in interference compromising the response signal received by the reader UE.

One or more aspects of this disclosure provides a mechanism controlling to avoid or mitigate interference generate by an AIoT device.

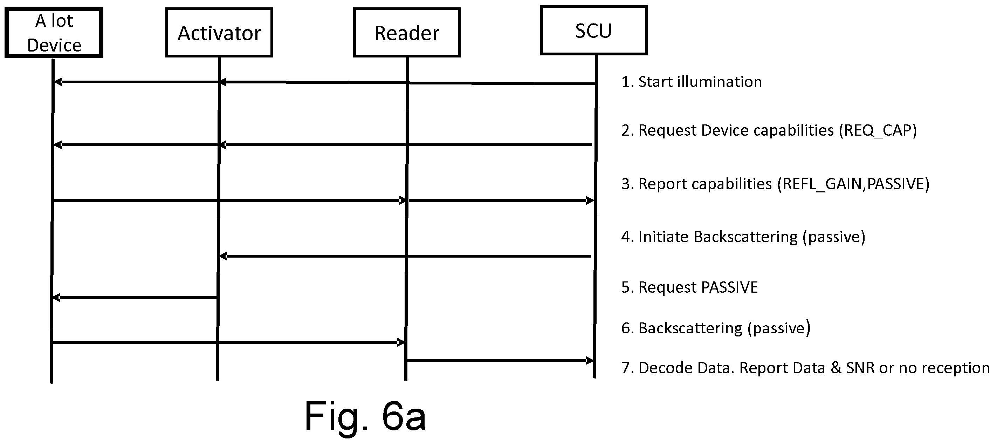

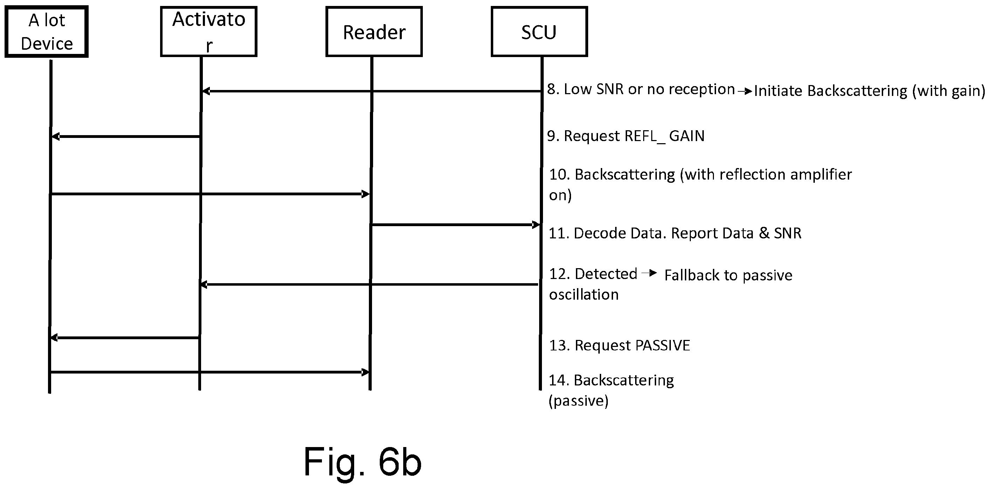

Fig. 6 shows a signaling diagram of a process for managing an AIoT device. The AIoT device may be an AIoT device type B AIoT device

At step 1, a session control unit (SCU) may transmit, to an activator UE or gNB, an indication to transmit, to the AIoT device, the activation signal. The activator UE or gNB may transmit, to the AIoT device, the activation signal.

The SCU may be part of the RAN (e.g., gNB) or the 5GC (e.g., location management function).

At step 2, the SCU may transmit, to the activator UE or gNB, an indication to transmit, to the AIoT device, a request to transmit, to the activator UE or gNB, capability information.

The capability information may indicate a capability to operate the AIoT device in at least one transmission mode for transmitting a response signal to the activation signal.

The at least one transmission mode may comprise a first transmission mode wherein the response signal is transmitted by backscattering the activation signal without amplification.

It will be understood that in the first transmission mode the response signal may be transmitted by backscattering the activation signal with modulation and without amplification. Alternatively, in the first transmission mode the response signal may be transmitted by backscattering the activation signal without modulation and without amplification.

The at least one transmission mode may comprise a second transmission mode wherein the response signal is transmitted by backscattering the activation signal with amplification to transmit the response signal.

It will be understood that in the second transmission mode the response signal may be transmitted by backscattering the activation signal with modulation and with amplification to transmit the response signal. Alternatively, in the second transmission mode the response signal may be transmitted by backscattering the activation signal without modulation and with amplification to transmit the response signal.

The capability information may indicate at least one reflection gain supported by the AIoT device (e.g., a range of reflection gains supported by the AIoT device). The at least one reflection gain may be expressed in decibel (dB).

At step 3, the AIoT device may transmit, to the activator UE or gNB, the capability information.

### First transmission mode

At step 4, the SCU may determine to operate the AIoT device in the first transmission mode based on the capability information. The SCU may transmit, to the activator UE or gNB, a request to operate the AIoT device in the first transmission mode.

At step 5, the activator UE or gNB may transmit, to the AIoT device, a request to operate the AIoT device in the first transmission mode.

At step 6, the AIoT device may operate the AIoT device in the first transmission mode. The AIoT device may transmit, to a reader UE or gNB, the response signal. The reader UE or gNB may perform a signal to noise ratio (SNR) measurement of the response signal. The reader UE or gNB may perform a received signal strength indicator (RSSI) measurement of the response signal.

At step 7, if the SNR measurement of the response signal is above a SNR threshold, the reader UE or gNB may decode the response signal. The reader UE or gNB may transmit, to the SCU, an indication of successful decoding. The reader UE or gNB may transmit, to the SCU, an indication of the SNR measurement. The reader UE or gNB may transmit, to the SCU, data obtained by decoding the response signal.

If the SNR measurement of the response signal is below a SNR threshold, the reader UE or gNB may not decode the response signal. The reader UE or gNB may transmit, to the SCU, an indication of unsuccessful decoding. The reader UE or gNB may transmit, to the SCU, an indication of the SNR measurement. The reader UE or gNB may not transmit, to the SCU, data obtained by decoding the response signal.

### Second transmission mode

At step 8, the SCU may determine to operate the AIoT device in the second transmission mode based on the capability information and the SNR measurement. The SCU may transmit, to the activator UE or gNB, a request to operate the AIoT device in the second transmission mode.

At step 9, the activator UE or gNB may transmit, to the AIoT device, a request to operate the AIoT device in the second transmission mode.

At step 10, the AIoT device may operate the AIoT device in the second transmission mode. The AIoT device may transmit, to the reader UE or gNB, the response signal. The reader UE or gNB may perform a SNR measurement of the response signal. The reader UE or gNB may perform a RSSI measurement of the response signal.

At step 11, if the SNR measurement of the response signal is above a SNR threshold, the reader UE or gNB may decode the response signal. The reader UE or gNB may transmit, to the SCU, an indication of successful decoding. The reader UE or gNB may transmit, to the SCU, an indication of the SNR measurement. The reader UE or gNB may transmit, to the SCU, data obtained by decoding the response signal.

If the SNR measurement of the response signal is below a SNR threshold and the RSSI is above a RSSI threshold, the reader UE or gNB may not decode the response signal. The reader UE or gNB may transmit, to the SCU, an indication of unsuccessful decoding. The reader UE or gNB may transmit, to the SCU, an indication of the SNR measurement. The reader UE or gNB may transmit, to the SCU, an indication of the RSSI measurement. The reader UE or gNB may not transmit, to the SCU, data obtained by decoding the response signal.

First transmission mode or second transmission mode with reduced transmission power, alternative modulation or alternative activation signal

At step 12, the SCU may determine that the reflection amplifier may become unstable and start oscillating based on the SNR measurement and the RSSI measurement. The SCU may attempt to address this issue.

The SCU may determine to operate the AIoT device in the first transmission mode based on the capability information, the SNR measurement and the RSSI measurement.

Alternatively, the SCU may determine to operate the AIoT device in the second transmission mode with a reduced transmission power (e.g., with a reduced reflection gain) based on the capability information, the SNR measurement and the RSSI measurement.

Alternatively, the SCU may determine to operate the AIoT device in the second transmission mode with an alternative modulation (e.g., on-off keying modulation) based on the capability information, the SNR measurement and the RSSI measurement.

Alternatively, the SCU may determine to operate the AIoT device in the second transmission mode with an alternative activation signal (e.g., activation signal transmitted by a different activator UE or gNB) based on the capability information, the SNR measurement and the RSSI measurement.

At step 12, the activator UE or gNB may transmit, to the AIoT device, a request to operate the AIoT device in the first transmission mode.

Alternatively, the activator UE or gNB may transmit, to the AIoT device, a request to operate the AIoT device in the second transmission mode with a reduced transmission power.

Alternatively, the activator UE or gNB may transmit, to the AIoT device, a request to operate the AIoT device in the second transmission mode with an alternative modulation.

Alternatively, the activator UE or gNB may transmit, to the AIoT device, a request to operate the AIoT device in the second transmission mode with an alternative activation signal.

At step 14, the AIoT device may operate the AIoT device in the first transmission mode.

Alternatively, the AIoT device may operate the AIoT device in the second transmission mode with a reduced transmission power.

Alternatively, the AIoT device may operate the AIoT device in the second transmission mode with an alternative modulation.

Alternatively, the AIoT device may operate the AIoT device in the second transmission mode with an alternative activation signal

The AIoT device may transmit, to the reader UE or gNB, the response signal.

The above mechanism may be advantageous in that it may allow to increase the SNR measured by the reader UE or gNB by switching from the first transmission mode to the second transmission mode.

The above mechanism may be advantageous in that it may allow to avoid or mitigate potential interference generated by the AIoT device and reduce power consumption at the AIoT device by switching from the second transmission mode to the first transmission mode or by switching from the second transmission mode to the second transmission mode with reduced transmission power.

The above mechanism may be advantageous in that it may allow to reduce power consumption of the AIoT device by switching from the second transmission mode to the second transmission mode with alternative modulation or with alternative activation signal.

One or more aspect of this disclosure relates to an architecture of an AIoT device to selectively operate in the first transmission mode or the second transmission mode.

An AIoT device type B AIoT device typically comprises an antenna and a reflection amplifier connected directly to the antenna. A bias of the reflection amplifier may be selectively switched on and switched off to perform a binary modulation. This may have two limitations.

A first limitation may be that the AIoT device may operate in the second transmission mode but may not operate in the first transmission mode.

A second limitation may be that when the AIoT device operates in the second transmission mode and the bias of the reflection amplifier is switched off, the antenna is connected to an equivalent passive load and backscattering at this stage is not done with gain, resulting in lower average SNR.

The second limitation may be mitigated by placing a BPSK modulator between the reflection amplifier and the antenna. This may effectively achieve a reflection gain during both modulation states and maximizes average SNR. However, in this case the first limitation may not be addressed. The BPSK modulator is always connected to the reflection amplifier.

One or more aspect of this disclosure relates to an architecture of an AIoT device that address both the first limitation and the second limitation, for example by providing means to selectively connect the BPSK modulator to the reflection amplifier.

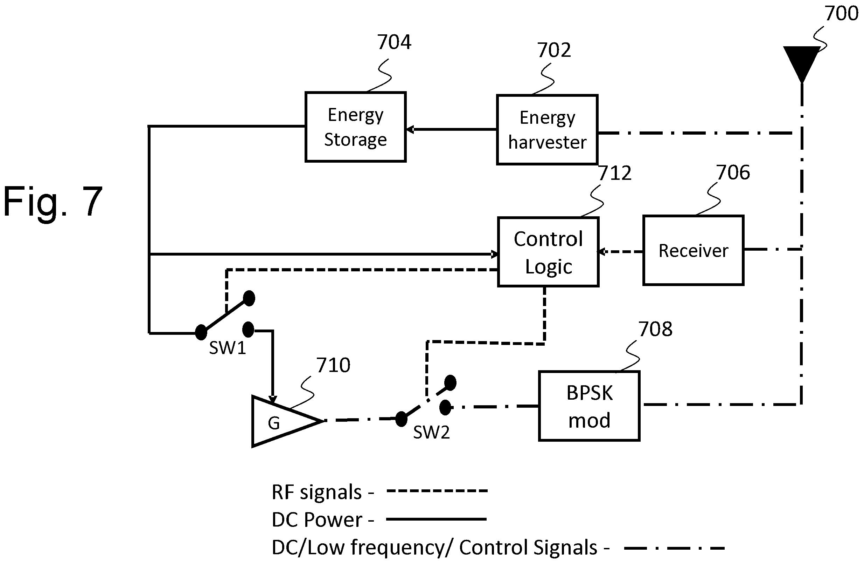

Fig. 7 shows a schematic representation of an AIoT device. The AIoT device may be an AIoT device type B AIoT device capable of operating like an AIoT device type AAloT device, or vice versa.

The AIoT device may comprise an antenna 700.

The AIoT device may or may not comprise an energy harvester 702 connected to the antenna 700.

The AIoT device may comprise an energy storage 704 connected to the energy harvester 702.

The AIoT device may comprise a receiver 706 connected to the antenna 700.

The AIoT device may comprise a modulator 708 connected to the antenna 700. The modulator may be a BPSK modulator.

The AIoT device may comprise a reflection amplifier 710.

The AIoT device may comprise a switch SW1 (e.g., direct current power switch) connected to the energy storage 704 and the reflection amplifier 710. The switch SW1 may be connected to the energy storage 704 and a bias of the reflection amplifier 710.

The AIoT device may comprise a switch SW2 (e.g., radio frequency switch) connected to the reflection amplifier 710 and the modulator 708. The switch SW2 may be connected to an input/output of the reflection amplifier 710 and the modulator 708.

The AIoT device may comprise a control logic 712 connected to the energy storage 704 and the receiver. The control logic 712 may be connected to the switch SW1 and the switch SW2. The control logic 712 may control the switch SW1 to selectively connect the energy storage 704 to the reflection amplifier 710 or disconnect the energy storage 704 from the reflection amplifier 710. The control logic 712 may control the switch SW1 to selectively increase the bias (and therefore increase the reflection gain) of the reflection amplifier 710 or decrease the bias (and therefore decrease the reflection gain) of the reflection amplifier 710. The control logic 712 may control the switch SW2 to selectively connect the reflection amplifier 710 to the modulator 708 or disconnect the reflection amplifier 710 from the modulator 708.

When the AIoT device operates in the first transmission mode, the control logic 712 may control the switch SW1 to disconnect the energy storage 704 from the reflection amplifier 710 (i.e., the bias is switched off). The control logic 712 may control the switch SW2 to disconnect the reflection amplifier 710 from the modulator 708.

When the AIoT device operates in the second transmission mode, the control logic 712 may control the switch SW2 to connect the energy storage 704 to the reflection amplifier 710 (i.e., the bias is switched on). The control logic 712 may control the switch SW2 to connect the reflection amplifier 710 to the modulator 708.

In an implementation, the modulator 708 may operate as a "true" BPSK modulator. The modulator 708 may be reflective in both modulation states.

In an implementation, the modulator 708 may operate as a "false" BPSK modulator. The modulator 708 may operate as an on off modulator, for example when the AIoT device operates in the first transmission mode. The modulator may be reflective in one modulation state.

In an implementation, the AIoT device may comprise a switch SW3 between the antenna and the harvester. The control logic 712 may control the switch SW3 to selectively connect the antenna to the energy harvester 702 (e.g., when the modulator 708 is not reflective) and disconnect the antenna from the energy harvester 702 (e.g., when the modulator is reflective).

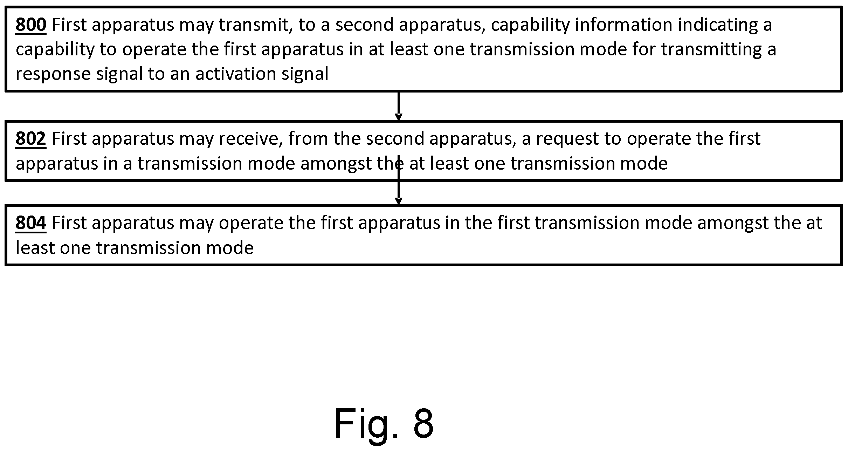

Fig. 8 shows a block diagram of a process for managing an AIoT device.

At step 800, a first apparatus may transmit, to a second apparatus, capability information indicating a capability to operate the first apparatus in at least one transmission mode for transmitting a response signal to an activation signal.

At step 802, the first apparatus may receive, from the second apparatus, a request to operate the first apparatus in a transmission mode amongst the at least one transmission mode.

At step 804, the first apparatus may operate the first apparatus in the first transmission mode amongst the at least one transmission mode.

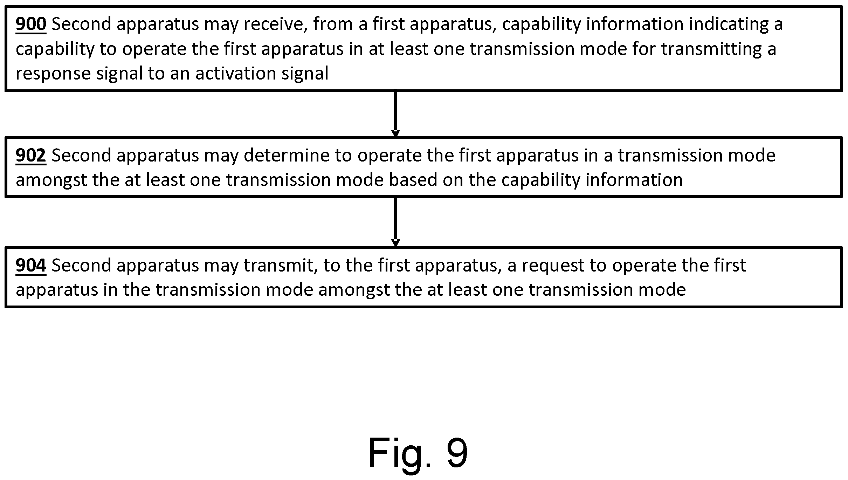

Fig. 9 shows a block diagram of a process for managing an AIoT device.

At step 900, a second apparatus may receive, from a first apparatus, capability information indicating a capability to operate the first apparatus in at least one transmission mode for transmitting a response signal to an activation signal.

At step 902, the second apparatus may determine to operate the first apparatus in a transmission mode amongst the at least one transmission mode based on the capability information.

At step 904, the second apparatus may transmit, to the first apparatus, a request to operate the first apparatus in the transmission mode amongst the at least one transmission mode.

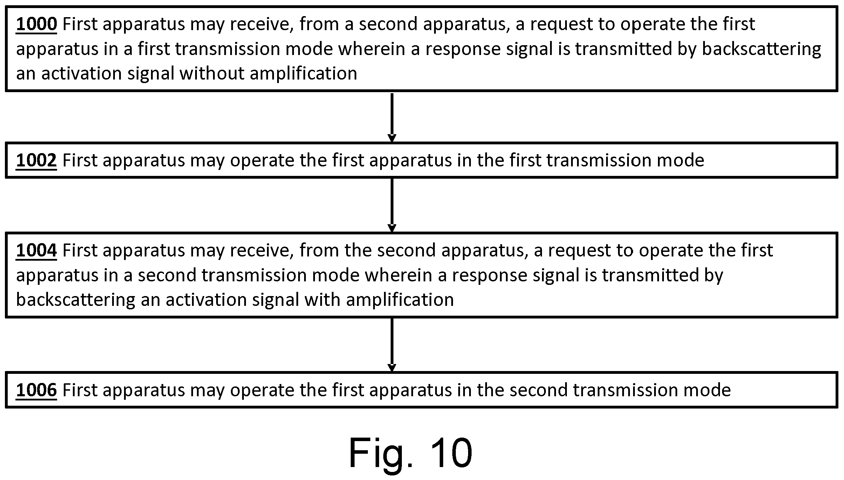

Fig. 10 shows a block diagram of a process for managing an AIoT device.

At step 1000, a first apparatus may receive, from a second apparatus, a request to operate the first apparatus in a first transmission mode wherein a response signal is transmitted by backscattering an activation signal without amplification.

At step 1002, the first apparatus may operate the first apparatus in the first transmission mode.

At step 1004, the first apparatus may receive, from the second apparatus, a request to operate the first apparatus in a second transmission mode wherein a response signal is transmitted by backscattering an activation signal with amplification.

At step 1006, the first apparatus may operate the first apparatus in the second transmission mode.

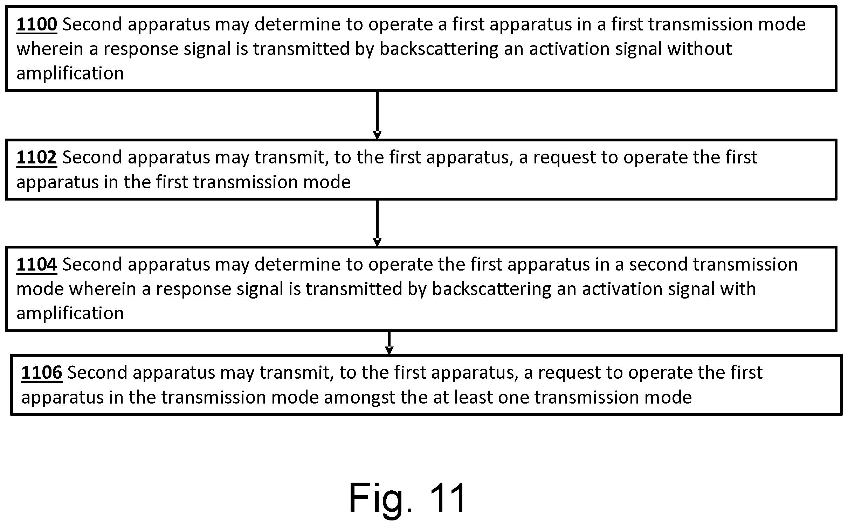

Fig. 11 shows a block diagram of a process for managing an AIoT device.

At step 1100, a second apparatus may determine to operate a first apparatus in a first transmission mode wherein a response signal is transmitted by backscattering an activation signal without amplification.

At step 1102, the second apparatus may transmit, to the first apparatus, a request to operate the first apparatus in the first transmission mode.

At step 1104, the second apparatus may determine to operate the first apparatus in a second transmission mode wherein a response signal is transmitted by backscattering an activation signal with amplification.

At step 1106, the second apparatus may transmit, to the first apparatus, a request to operate the first apparatus in the transmission mode amongst the at least one transmission mode.

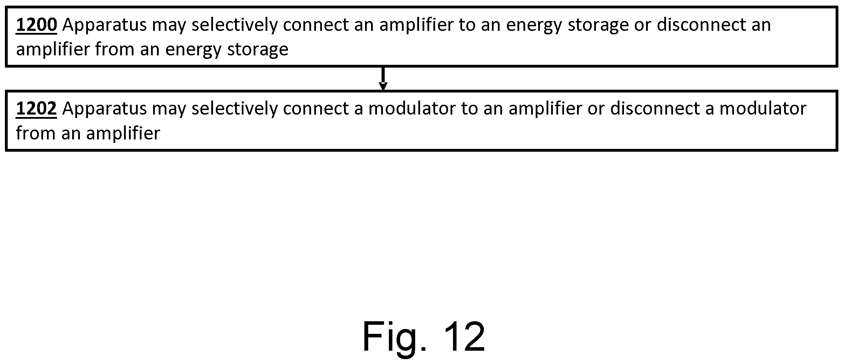

Fig. 12 shows a block diagram of a process for managing an AIoT device.

At step 1200, an apparatus may selectively connect an amplifier to an energy storage or disconnect an amplifier from an energy storage.

At step 1202, the apparatus may selectively connect a modulator to an amplifier or disconnect a modulator from an amplifier.

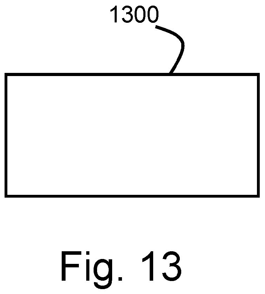

Fig. 13 shows a schematic representation of non-volatile memory media 1300 storing instructions which when executed by a processor allow the processor to perform one or more of the steps of the methods of Fig. 8 to Fig. 12.

It is noted that while the above describes example embodiments, there are several variations and modifications which may be made to the disclosed solution without departing from the scope of the present invention.

It will be understood that although the above concepts have been discussed in the context of a 5GS, one or more of these concepts may be applied to other cellular systems.

The embodiments may thus vary within the scope of the attached claims. In general, some embodiments may be implemented in hardware or special purpose circuits, software, logic or any combination thereof. For example, some aspects may be implemented in hardware, while other aspects may be implemented in firmware or software which may be executed by a controller, microprocessor or other computing device, although embodiments are not limited thereto. While various embodiments may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments may be implemented by computer software stored in a memory and executable by at least one data processor of the involved entities or by hardware, or by a combination of software and hardware. Further in this regard it should be noted that any procedures, e.g., as in Fig. 8 to Fig. 12, may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, CD.

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs), application specific integrated circuits (ASIC), gate level circuits and processors based on multi-core processor architecture, as non-limiting examples.

Alternatively or additionally some embodiments may be implemented using circuitry. The circuitry may be configured to perform one or more of the functions and/or method steps previously described. That circuitry may be provided in the base station and/or in the communications device.

As used in this application, the term "circuitry" may refer to one or more or all of the following:
(a) hardware-only circuit implementations (such as implementations in only analogue and/or digital circuitry);
(b) combinations of hardware circuits and software, such as:
   (i) a combination of analogue and/or digital hardware circuit(s) with software/firmware and
   (ii) any portions of hardware processor(s) with software (including digital signal processor(s)), software, and memory(ies) that work together to cause an apparatus, such as the communications device or base station to perform the various functions previously described; and
(c) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example integrated device.

The term "means" as used in the description and in the claims may refer to one or more individual elements configured to perform the corresponding recited functionality or functionalities, or it may refer to several elements that perform such functionality or functionalities. Furthermore, several functionalities recited in the claims may be performed by the same individual means or the same combination of means. For example, performing such functionality or functionalities may be caused in an apparatus by a processor that executes instructions stored in a memory of the apparatus.

The foregoing description has provided by way of exemplary and non-limiting examples a full and informative description of some embodiments However, various modifications and adaptations may become apparent to those skilled in the relevant arts in view of the foregoing description, when read in conjunction with the accompanying drawings and the appended claims. However, all such and similar modifications of the teachings will still fall within the scope as defined in the appended claims.

## Claims

1. An apparatus comprising:
an energy storage;
an antenna;
a modulator connected to the antenna;
an amplifier;
means for selectively connecting the amplifier to the energy storage or disconnecting the amplifier from the energy storage; and
means for selectively connecting the modulator to the amplifier or disconnecting the modulator from the amplifier.

2. The apparatus of claim 1, wherein the means for selectively connecting the amplifier to the energy storage or disconnecting the amplifier from the energy storage comprise means for selectively connecting a bias of the amplifier to the energy storage or disconnecting a bias of the amplifier from the energy storage.

3. The apparatus of claim 1 or claim 2, wherein the means for selectively connecting the amplifier to the energy storage or disconnecting the amplifier from the energy storage comprise a first switch.

4. The apparatus of any of claims 1 to 3, wherein the means for selectively connecting the modulator to the amplifier or disconnected the modulator from the amplifier comprise a second switch.

5. The apparatus of any of claims 1 to 4, wherein the amplifier is a reflection amplifier.

6. The apparatus of any of claims 1 to 5, wherein the modulator is a binary phase shift keying modulator.

7. The apparatus of any of claims 1 to 6, wherein the modulator is an on off keying modulator.

8. The apparatus of any of claims 1 to 7, comprising:
means for receiving, from a second apparatus, a request to operate the apparatus in a first transmission mode wherein a response signal is transmitted by backscattering an activation signal without amplification;
means for transmitting a control signal to the means for selectively connecting the amplifier to the energy storage or disconnecting the amplifier from the energy storage so that the amplifier is disconnected from the energy storage; and
means for transmitting a control signal to the means for connecting the modulator to the amplifier or disconnected from the amplifier so that the modulator is disconnected from the amplifier.

9. The apparatus of any of claims 1 to 8, comprising:
means for receiving, from a second apparatus, a request to operate the apparatus in a second transmission mode wherein a response signal is transmitted by backscattering an activation signal with amplification;
means for transmitting a control signal to the means for selectively connecting the amplifier to the energy storage or disconnecting the amplifier from the energy storage so that the amplifier is connected to the energy storage; and
means for transmitting a control signal to the means for connecting the modulator to the amplifier or disconnected from the amplifier so that the modulator is connected to the amplifier.

10. The apparatus of any of claims 1 to 9, comprising:
means for selectively increasing a gain of the amplifier or decreasing a gain of the amplifier.

11. The apparatus of any of claims 1 to 10, wherein the apparatus is an ambient Internet of things device.

12. The apparatus of any of claims 1 to 11, wherein the apparatus is an ambient Internet of things device type B ambient Internet of things device.

13. The apparatus of any of claims 1 to 12, wherein the second apparatus is a session control unit.

14. A method performed by an apparatus comprising an energy storage, an antenna, a modulator connected to the antenna and an amplifier, comprising:
selectively connecting the amplifier to the energy storage or disconnecting the amplifier from the energy storage; and
selectively connecting the modulator to the amplifier or disconnecting the modulator from the amplifier.

15. A computer program comprising computer executable instructions which when run on one or more processors perform the steps of the method of claim 14.
